# EUROPEAN PATENT SPECIFICATION

(11) **EP 4 405 190 B1**
(45) Date of publication and mention of the grant of the patent: **06.05.2026**
(21) Application number: 22783040.3
(22) Date of filing: 23.09.2022
(51) Int. Cl.: B60K 11/02, B60K 1/00

(54) **THERMAL MANAGEMENT SYSTEM FOR ELECTRIC POWERTRAINS**
THERMISCHES MANAGEMENTSYSTEM FÜR ELEKTRISCHE ANTRIEBE
SYSTÈME DE GESTION THERMIQUE POUR DES PROPULSEURS ÉLECTRIQUES

(30) Priority: 23.09.2021 IT 202100024498
(43) Date of publication of application: 31.07.2024
(73) Proprietor: Dumarey Automotive Italia S.p.A., 10129 Torino (IT)
(72) Inventor: BUZZI, Luca, 10129 Torino (IT); DI PIERRO, Claudio, 10129 Torino (IT); MAFRICI, Salvatore, 10129 Torino (IT); SPAZIAN, Andrea, 10129 Torino (IT)
(74) Representative: Bruni, Giovanni
(86) International application number: PCT/IB2022/059025
(87) International publication number: WO 2023/047353

(56) References cited:
- EP-A1- 2 270 918
- US-A1- 2021 088 124
- US-A1- 2021 188 043
- US-A1- 2021 221 255
- US-B2- 10 476 051

## Description

### Field of the invention

The present invention relates to an innovative thermal management system for an electric powertrain of an electric vehicle. More specifically, the thermal management system is able to provide heating and cooling of the different subsystems independently but using a single circuit and a single carrier fluid. Furthermore, this system can interact with the entire air conditioning system of the electric vehicle.

### Background art

As is known, an electric propulsion system for electric vehicles essentially comprises the following components:
- an electric motor, consisting of a stator and a rotor that generate two magnetic fields whose interaction produces the driving torque used for propulsion. Electric motors can be powered by direct or alternating current and be of the synchronous type (more frequently) but also, in some applications, of the asynchronous type;
- an inverter/converter that equips both AC motors and DC motors. The inverter, comprising dedicated electronics with some power transistors on board driven by a microcontroller, serves to regulate the speed of the vehicle by varying the frequency of the current that powers the electric motor;
- a speed reducer which reduces the rotation speed of the electric motor, increasing the drive torque transmitted to the vehicle wheels;
- an energy source, typically a lithium-ion battery or other type, for example a device with fuel cells.

A fundamental aspect for the correct functioning of an electric powertrain is the temperature control of the various components, so that they can be used at their maximum efficiency.

In fact, the efficiency of the electric motor decreases with the increase of the stator/rotor temperature: for example, a reduction of the temperature from 170°C to 150°C on the stator/rotor group could increase the efficiency of the electric motor.

As for the inverter, the conduction losses of the junction and the switching losses increase with the increase of the temperature of the junction: for example, a temperature reduction of 20°C could result in a 2.5% reduction in total losses.

In the speed reducer, on the other hand, the friction losses decrease with the increase of the lubrication oil temperature: for example, passing from 60°C to 90°C a reduction of 2% of the loss of transmitted torque could be obtained.

As you can see, these components have contrasting needs from a thermal point of view: while the temperature reduction is beneficial for the motor and the inverter, an increase in temperature is beneficial for the speed reducer.

A thermal management system for an electric powertrain is known from US 10 476 051 B2. Current thermal management systems for an electric powertrain provide for the use of a dedicated cooling circuit, for example a circuit in which the heat is removed from a mixture of water and glycol, or a direct heat exchange cooling circuit, for example, using a carrier fluid such as a dielectric oil.

However, these circuits provide for the simultaneous cooling (or, in some cases, heating) of all subsystems of the electric powertrain. In other words, known cooling circuits do not allow the various components to work with the maximum of their respective efficiency: for example, in the case of simultaneous cooling, due to the conflicting needs of these components, the electric motor and the inverter will benefit, while the speed reducer will be penalized.

There is therefore a need to solve the aforementioned technical problem by means of an innovative thermal management system for electric powertrain.

### Summary of the Invention

The aim of the present invention is to realize an innovative thermal management system for an electric powertrain of an electric vehicle.

The invention consists in the fact that the thermal management system is able to separately manage the heating and cooling of the subsystems of the electric powertrain.

In particular, the thermal management system, by means of a single circuit crossed by a single carrier fluid, for example, dielectric oil, is separately enslaved to an electric motor, an inverter, a speed reducer and a source of energy (battery, fuel cell device and similar) with appropriate adjustment devices.

According to the invention, the thermal management system can operate according to multiple operating modes that implement different heating/ cooling strategies.

Preferably, the thermal management system according to the invention will be able to interact with the air conditioning system of the entire electric vehicle equipped with the electric powertrain.

By means of the present invention, therefore, the performance of the electric powertrain is optimized in terms of efficiency, duration and effectiveness of the heating.

Therefore, according to an aspect of the present invention a thermal management system for electric powertrain is provided, the system having the characteristics set forth in the independent product claim 1.

According to another aspect of the present invention a method of operating the thermal management system for electric powertrain is provided, the method having the characteristics set forth in the independent method claim 8.

Further preferred and/or particularly advantageous embodiments of the invention are described according to the features set forth in the attached dependent claims.

### Brief description of the Drawings

The invention will now be described with reference to the appended drawings, which illustrate a non-limiting example embodiment, wherein:
- Figure 1 schematically illustrates a thermal management system of an electric powertrain according to a first embodiment of the present invention,
- Figure 1a schematically illustrates the thermal management system of Figure 1 in a first operating mode,
- Figure 1b schematically illustrates the thermal management system of Figure 1 in a second operating mode,
- Figure 1c schematically illustrates the thermal management system of Figure 1 in a third operating mode,
- Figure 1d schematically illustrates the thermal management system of Figure 1 in a fourth operating mode,
- Figure 1e schematically illustrates the thermal management system of figure 1 in a fifth operating mode,
- Figure 1f schematically illustrates the thermal management system of Figure 1 in a sixth operating mode,
- Figure 1g schematically illustrates the thermal management system of Figure 1 in a seventh operating mode,
- Figure 1h schematically illustrates the thermal management system of figure 1 in an eighth operating mode,
   Figure 2 schematically illustrates the thermal management system of the electric powertrain in a second and preferred embodiment of the present invention,
- Figure 3 schematically illustrates the air conditioning system of an electric vehicle with which the thermal management system of Figure 2 interacts,
- Figure 4 schematically illustrates a first operating mode of the thermal management system of Figure 2,
- Figures 4a and 4b schematically illustrate the conditioning system of the electric vehicle of Figure 3 in its interaction with the thermal management system operating according to the first (or second) operating mode,
- Figure 5 schematically illustrates a second operating mode of the thermal management system of Figure 2,
- Figure 6 schematically illustrates a third operating mode of the thermal management system of Figure 2,
- Figure 6a schematically illustrates the air conditioning system of the electric vehicle of Figure 3 in its interaction with the thermal management system in the third operating mode,
- Figure 7 schematically illustrates a fourth operating mode of the thermal management system of Figure 2,
- Figure 7a schematically illustrates the air conditioning system of the electric vehicle of Figure 3 in its interaction with the thermal management system in the fourth operating mode,
- Figure 8 schematically illustrates a fifth operating mode of the thermal management system of Figure 2,
   Figure 8a schematically illustrates the air conditioning system of the electric vehicle of Figure 3 in its interaction with the thermal management system in the fifth operating mode,
- Figure 9 schematically illustrates a sixth operating mode of the thermal management system of Figure 2,
- Figure 10 schematically illustrates a seventh operating mode of the thermal management system of Figure 2,
- Figures 10a and 10b schematically illustrate the conditioning system of the electric vehicle of Figure 3 in its interaction with the thermal management system operating according to the seventh operating mode,
- Figure 11 schematically illustrates an eighth operating mode of the thermal management system of Figure 2,
- Figure 12 schematically illustrates a ninth operating mode of the thermal management system of Figure 2,
- Figure 12a schematically illustrates the air conditioning system of the electric vehicle of Figure 3 in its interaction with the thermal management system in the ninth operating mode,
- Figure 13 schematically illustrates a tenth operating mode of the thermal management system of Figure 2,
- Figure 13a schematically illustrates the air conditioning system of the electric vehicle of Figure 3 in its interaction with the thermal management system in the tenth operating mode,
- Figure 14 is a block diagram illustrating a method of operating the thermal management system of Figure 1 or the thermal management system of Figure 2, and
- Figure 15 is a graph that illustrates the temperature trend of the components of the electric engine during a particular application of the method of Figure 14.

### Detailed Description

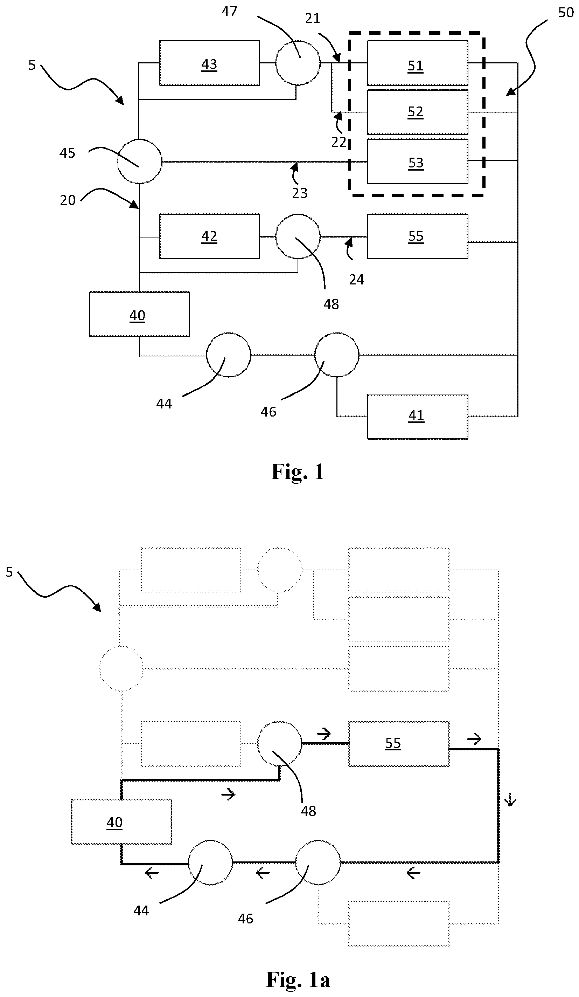

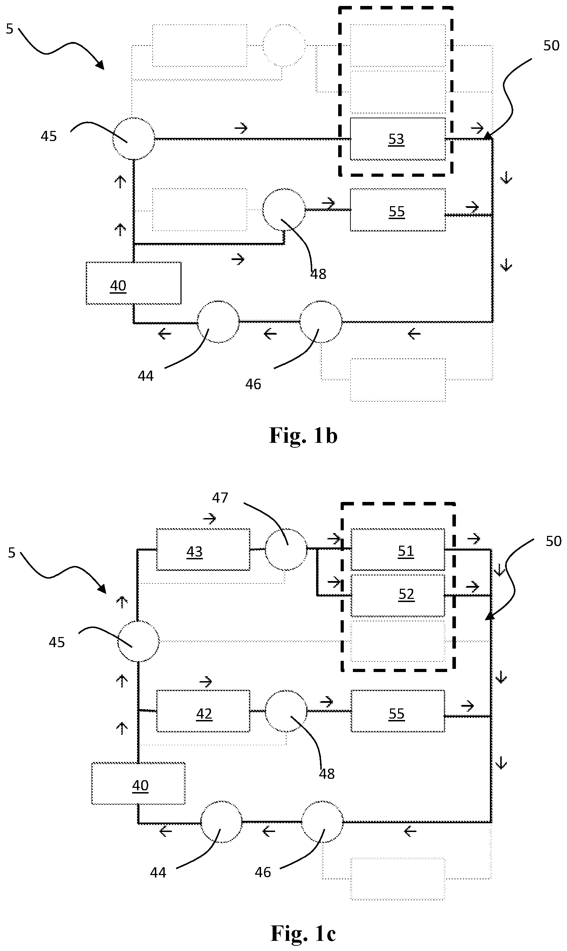

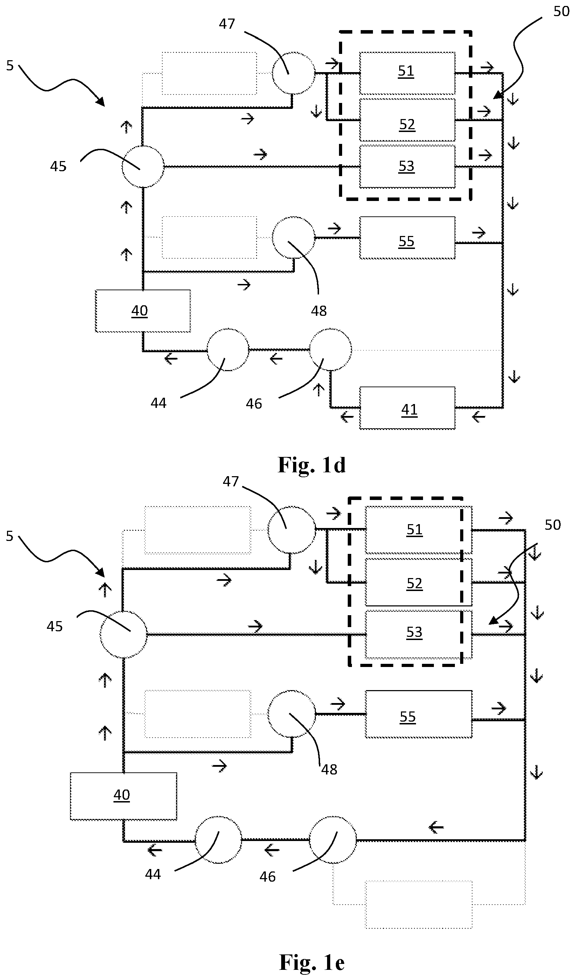

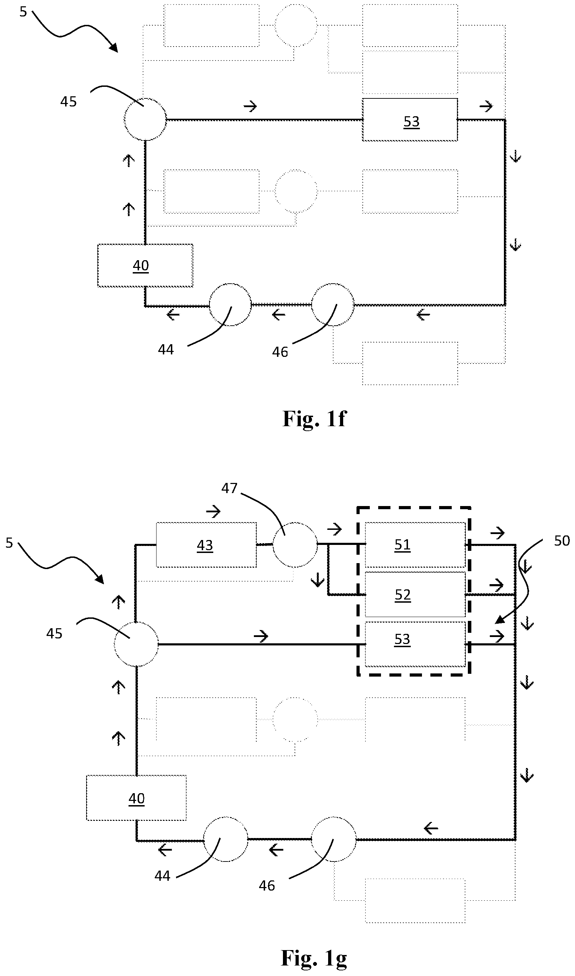

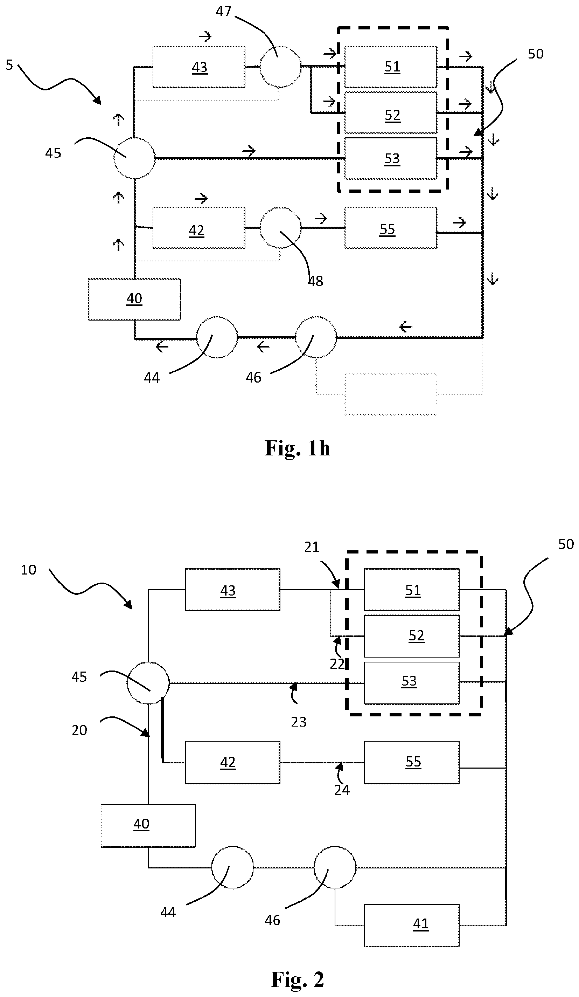

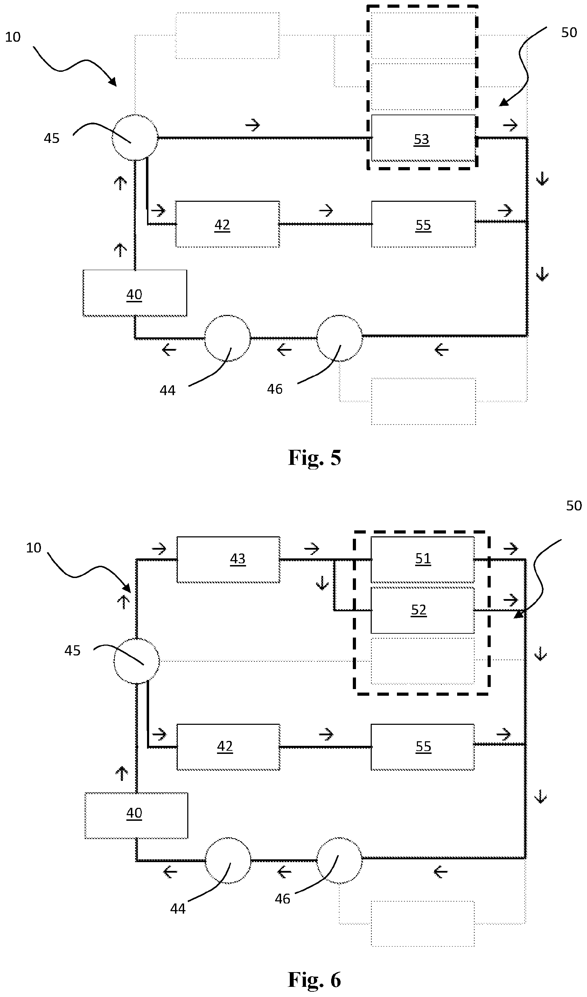

With reference to Figure 1, 5 indicates as a whole the thermal management system in an embodiment according to the present invention. The thermal management system 5 comprises a single circuit 20 traversed by a single carrier fluid, for example, dielectric oil. The layout of the circuit 20 will be discussed during the description of the operating modes of the thermal management system. By means of the circuit 20, the thermal management system interacts separately with the components of an electric powertrain 50, for example an inverter 51, an electric motor 52, a speed reducer 53 and with an energy source 55, for example, a battery or fuel cell device. The interaction is made possible by means of special heat exchange and regulation devices. In figure 1, according to the invention, a high voltage heater 40, heat exchangers 41, 42, 43 (in this case, ambient air/ carrier fluid radiators) are shown, a pump element 44, for the circulation of the carrier fluid, and a plurality of control valves 45, 46, 47, 48 (in the example illustrated in Figure 1 the control valves are four in number). In addition to the heat exchangers, there may also be heaters in the passenger compartment of the electric vehicle. For clarity: the first ambient air/carrier fluid radiator has the reference 42, the second ambient air/carrier fluid radiator has the reference 43, the third ambient air/carrier fluid radiator has the reference 41. In particular, the electric engine 50 exchanges heat with the thermal management system 5 by means of the carrier fluid conveyed in three branches 21, 22, 23 of the circuit 20 which are independent from each other, i.e., isolated, so that, for example, the cooling of the electric motor 51, the cooling of the inverter 52 and the heating of the speed reducer 53 (to reduce friction losses) are contemporaneous. A fourth branch 24 of the circuit 20, also independent from the previous ones, conveys the carrier fluid to the energy source 55 and, therefore, allows the heat exchange between the thermal management system and the energy source.

With reference to Figure 1a, a first operating mode of the thermal management system 5 is that of partial heating: that is, the heating of only the energy source 55 is carried out by means of the high voltage heater 40. According to this mode, the pump element 44, a first control valve 46, the high voltage heater 40 and a second control valve 48 are operative in the thermal management system 5.

With reference to Figure 1b, a second operating mode of the thermal management system 5 is again that of partial heating: in this case the heating of the energy source 55 and the speed reducer 53 of the electric powertrain 50 is carried out.

This second mode is completely similar to the previous one but with a third control valve 45 open to allow the heating of the speed reducer 53 as well.

Thus, in the thermal management system 5 the pump element 44, the first control valve 46, the high voltage heater 40, the second control valve 48 and the third control valve 45 are operative.

With reference to Figure 1c, a third operating mode of the thermal management system 5 is that of partial cooling, according to which it carries out the cooling of the energy source 55, of the inverter 51 and of the electric motor 52. The reducer 53, on the other hand, does not require cooling (typically when the temperature of the fluid in the speed reducer is lower than 90°C).

The first ambient air/carrier fluid radiator 42 removes heat from the energy source 55, while the second ambient air/carrier fluid radiator 43 removes heat from the inverter 51 and the electric motor 52. All the control valves 45, 46, 47, 48 are operative.

Thus, all components of the thermal management system 5 are operational in this mode, with the exception of the third ambient air / carrier fluid radiator 41 and the high voltage heater 40.

In a similar way, depending on the circumstances, the third ambient air/carrier fluid radiator 41 can be used instead of said first and second ambient air/carrier fluid radiator 42, 43.

With reference to Figure 1d, a fourth operating mode of the thermal management system 5 is that of total cooling, that is, the cooling of all the components involved. This operating mode takes place when both the energy source 55 and all the components of the electric powertrain 50 require cooling and the third ambient air/carrier fluid radiator 41 is used for this requirement.

Therefore, all the components of the thermal management system 5 can be operative in this mode, with the exception of said first and second ambient air/carrier fluid radiator 42, 43 and for the high voltage heater 40.

Similarly, depending on the circumstances, the first and second ambient air/carrier fluid radiator 42, 43 can also be used and, in this case, the third ambient air/carrier fluid radiator 41 should be used to remove the excess of heat.

With reference to Figure 1e, a fifth operating mode of the thermal management system 5 is that of total heating, i.e., heating of all the components of the electric powertrain 50 and of the energy source 55.

The high voltage heater 40 is switched on to ensure heating of all components. In the thermal management system 5, therefore, all the components are operational except for the ambient air/carrier fluid radiators 41, 42, 43.

With reference to Figure 1f, a sixth operating mode of the thermal management system 5 is that of partial heating, that is to say, heating only the speed reducer 53.

Also in this mode, the high voltage heater 40 is switched on. In the thermal management system 5, therefore, the pump element 44, the first control valve 46, the second control valve 45 and the high voltage heater 40 are operative.

With reference to Figure 1g, a seventh operating mode, particularly advantageous according to the purposes of the present invention, is the so-called hybrid one. According to this mode, the inverter 51 and the electric motor 52 require cooling. Conversely, the speed reducer 53 requires heating. The second ambient air/carrier fluid radiator 43 is used for cooling the inverter 51 and the electric motor 52. The high voltage heater 40 is on and supplies heat to the speed reducer 53.

Therefore, in this mode all the components of the thermal management system 5 are operational, except for the first 42 and for the third ambient air/carrier fluid radiator 41. It should be noted that in this operating mode the thermal management system 5 solves the technical problem underlying the present invention, that is to realize simultaneously and independently on the one hand the cooling of the electric motor and the inverter, and on the other hand the heating of the speed reducer.

With reference to Figure 1h, an eighth operating mode, also particularly advantageous according to the purposes of the present invention, is still a hybrid mode. According to this mode, the energy source 55, the inverter 51 and the electric motor 52 require cooling. Conversely, the speed reducer 53 requires heating. The first ambient air/carrier fluid radiator 42 is used for cooling the energy source 55 and the second ambient air/carrier fluid radiator 43 is used for cooling the inverter 51 and the electric motor 52. The high voltage heater 40 is switched on and supplies heat to the speed reducer 53.

Therefore, in this mode all the components of the thermal management system 5 are operational, with the exception of the third ambient air/carrier fluid radiator 41. It should be noted that also in this operating mode the thermal management system 5 solves the technical problem at the basis of the present invention, that is to realize simultaneously and independently on the one hand the cooling of the electric motor, the inverter and the energy source, on the other hand the heating of the speed reducer.

With reference to Figure 2, the thermal management system 10, in a second and preferred embodiment of the present invention, differs from the configuration illustrated in Figure 1 in that:
- the heat exchangers 42, 43 interact in the manner discussed below with the air conditioning system of the entire electric vehicle. In other words, these heat exchangers 42, 43 belong both to the thermal management system 10 of the electric powertrain and to the conditioning system 60 of the electric vehicle. Inside them, the heat exchange takes place between the dielectric oil of the circuit 20 and the carrier fluid of the conditioning system. Therefore, these heat exchangers can, depending on the needs, provide heat or absorb heat. For clarity: the first heat exchanger has the reference 42, the second heat exchanger has the reference 43. The heat exchanger 41, on the other hand, is an ambient air/carrier fluid (for example, dielectric oil) radiator;
- the control valves 45, 46 are only two in number.

Also in this configuration, the electric powertrain 50 exchanges heat with the thermal management system 10 by means of three branches 21, 22, 23 which are independent of each other so that, for example, the cooling of the electric motor 51, the cooling of the inverter 52 and the heating of the gearbox 53 are contemporaneous.

Also in this configuration, a fourth branch 24 of the circuit 20, also independent from the previous ones, conveys the carrier fluid to the energy source 55 and, therefore, allows the heat exchange between the thermal management system and the energy source.

Consequently, the interaction between the thermal management system 10 and the air conditioning system of the electric drive vehicle allows, for example, to be able to heat the energy source 55 and the speed reducer 53.

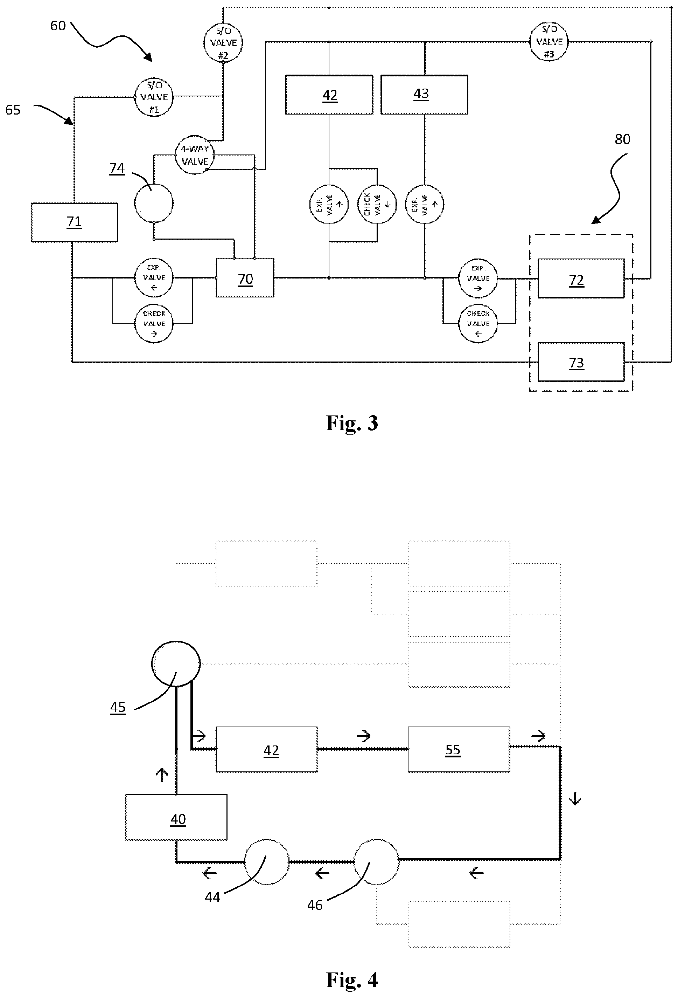

Before analyzing the possible operating modes of the thermal management system 10, the air conditioning system 60 of the electric vehicle is briefly described, an example of which is illustrated in figure 3. In this figure, the refrigerant circuit 65 and the main components including the two heat exchangers 42, 43 which are in common with the thermal management system 10 in the embodiment illustrated in Figure 2.

Also visible are:
- an accumulation drier filter 70 equipped with an internal heat exchanger,
- an ambient air condenser 71,
- an evaporator 72 in the passenger compartment 80 of the vehicle,
- a condenser 73 in the passenger compartment 80 of the vehicle,
- a compressor 74,
- a plurality of expansion valves (EXP VALVE), shut-off valves (S/O VALVE), check valves (CHECK VALVE) and a four-way valve (4-WAY VALVE).

The conditioning system 60 is not part of the present invention and, therefore, will not be described in detail. Instead, the different interactions with the thermal management system 10 will be described. It should be emphasized that the air conditioning system 60 can operate both in the refrigeration mode and in the heat pump mode.

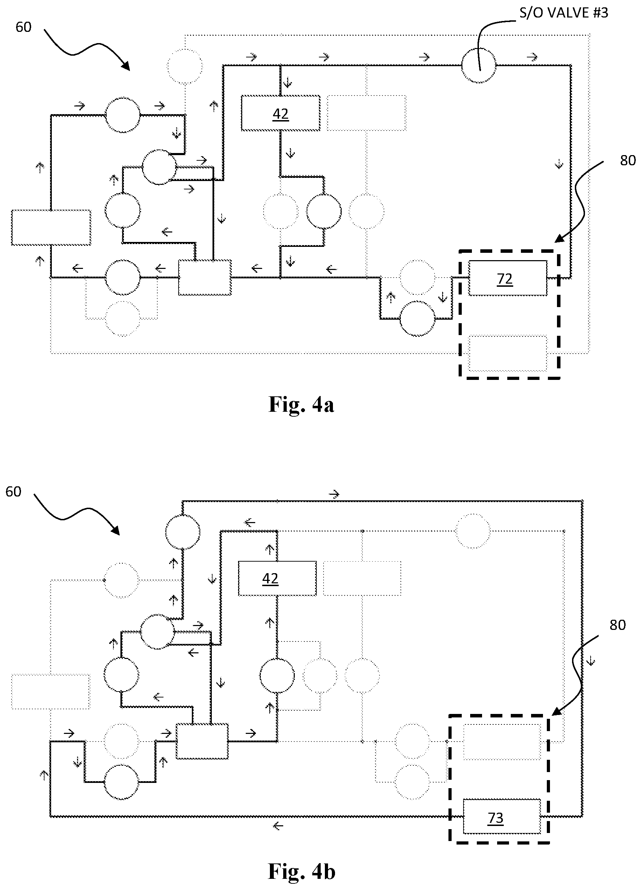

With reference to Figures 4, 4a, 4b, a first operating mode of the thermal management system 10 is that of partial heating, that is to say, heating only the energy source 55.

In particular, when the external ambient temperature is suitable for the operation of the conditioning system 60 according to the heat pump mode, the energy source 55 is heated by enabling this mode on the conditioning system 60, i.e., allowing the heat transfer from the external ambient to the energy source 55 through the first heat exchanger 42. In the thermal management system 10 the pump element 44, a first control valve 46, a second control valve 45 and the first heat exchanger 42 are operative. Depending on the circumstances, the high voltage heater 40 could be turned on to further increase the warm-up phase.

With reference to figure 4a, in the heat pump mode, the air conditioning system can also heat the passenger compartment 80 of the vehicle, by opening the third shut-off valve S/O VALVE#3 and using the evaporator 72 of the passenger compartment 80. This option is suitable because the air conditioning system 60 in the heat pump mode supplies thermal energy with a coefficient of performance (COP) greater than 1.

Since the air conditioning system 60 in the heat pump mode does not operate below certain temperatures (usually, for ambient temperatures below -10°C), when the outdoor ambient temperature is below -10°C it is necessary to activate the heater voltage 40 of the thermal management system 10 to heat the energy source 55.

The first heat exchanger 42 is used to transfer thermal energy to the passenger compartment 80 of the vehicle through the passenger compartment condenser 73 (Figure 4b).

With reference to Figure 5, a second operating mode of the thermal management system 10 is again that of partial heating. In this case, the heating of the energy source 55 and the speed reducer 53 of the electric powertrain 50 takes place.

This second mode is completely similar to the previous one but with the second control valve 45 open to allow the heating of the speed reducer 53 as well.

Thus, the pump element 44, the first control valve 46, the first heat exchanger 42 and a second regulating valve 45 are operational in the thermal management system 10. Depending on the circumstances, the high voltage heater 40 could be switched on to further increase the heating phase.

On the basis of the temperature value, the air conditioning system 60 can interact with the thermal management system 10 according to the heat pump mode or according to the chiller mode, in the same way as already described for the interaction with the first operating mode of the thermal management system.

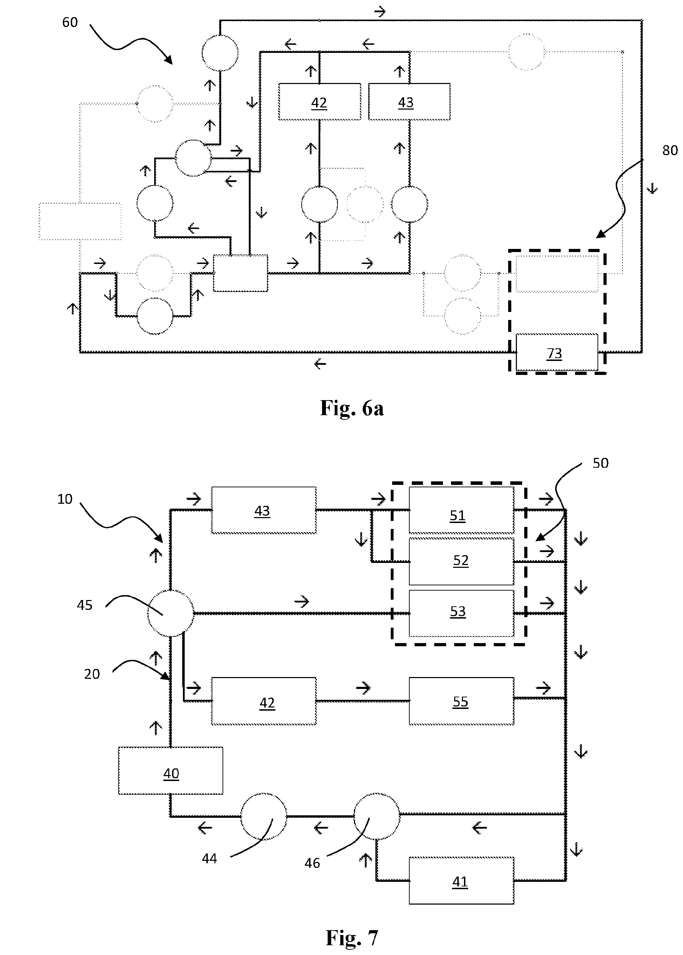

With reference to Figures 6 and 6a, a third operating mode of the thermal management system 10 is that of partial cooling, that is, the cooling of the energy source 55, the inverter 51 and the electric motor 52. The speed reducer 53, on the other hand, does not require cooling (typically when the temperature of the fluid in the speed reducer is below 90°C). At the same time, the passenger compartment 80 of the vehicle requires heating.

The first heat exchanger 42 removes heat from the energy source 55 and supplies it to the passenger compartment 80 by means of its condenser 73, while the second heat exchanger 43 removes heat from the inverter 51 and the electric motor 52 to supply further heat to the passenger compartment 80 again by means of the condenser 73. Hence the heating of the passenger compartment 80 is allowed as there is availability of thermal energy from the energy source 55, from the inverter 51, from the electric motor 52.

The first control valve 46 must be used to manage the exchange of thermal energy with the external environment, while the second control valve 45 must be used to select the most appropriate heat source to heat the passenger compartment 80 of the vehicle.

Thus, all components of the thermal management system 10 are operational in this mode, with the exception of the ambient air/carrier fluid radiator 41.

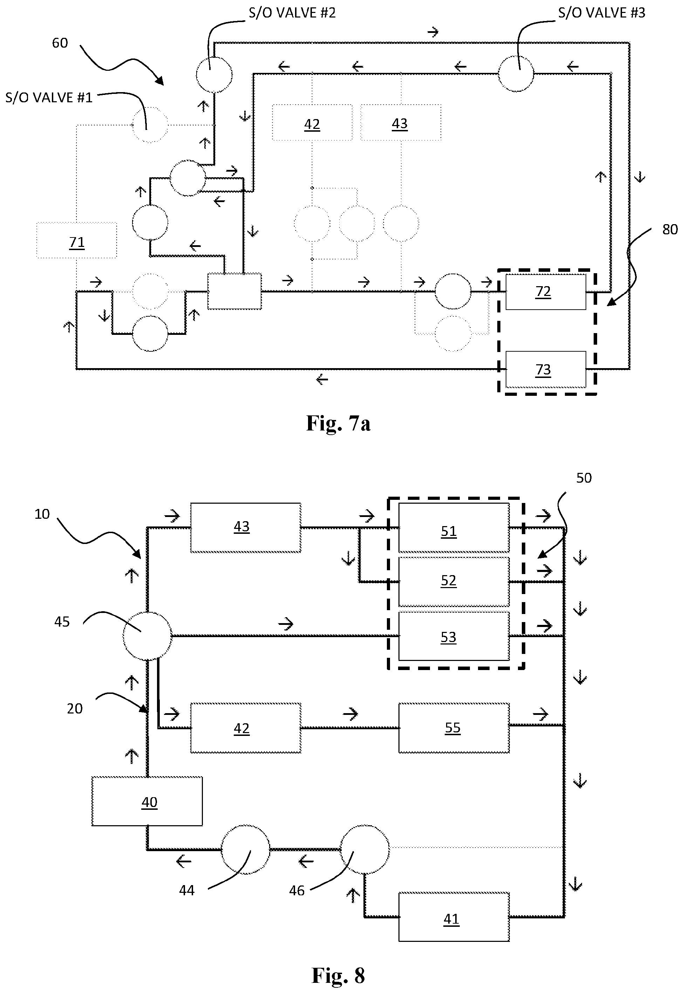

With reference to Figures 7 and 7a, a fourth operating mode of the thermal management system 10 is that of defrosting. The cooling of the fluid circuit is managed by the ambient air/carrier fluid radiator 41, while the first and second heat exchanger 42, 43 can be activated according to specific cooling needs. Thus, all components of the thermal management system 10 can be operational in this mode.

As regards the air conditioning system 60, both the evaporator 72 of the passenger compartment 80 (by opening the third on-off valve S/O VALVE#3) and the condenser 73 of the passenger compartment 80 (by opening the second shut-off valve S/O VALVE#2) are activated to allow defrosting.

The ambient air condenser 71 (by opening the first shut-off valve S/O VALVE#1) can be used for heat exchange with the external ambient, if necessary.

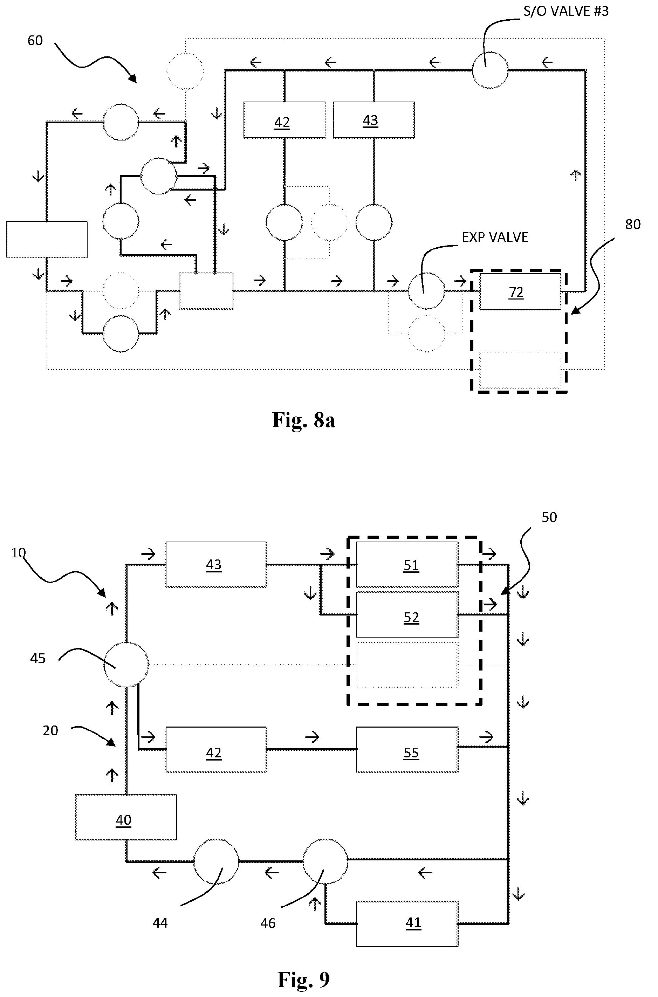

With reference to Figures 8 and 8a, a fifth operating mode of the thermal management system 10 is that of total cooling, that is, the cooling of all the components involved. This operating mode takes place when both the energy source 55 and all the components of the electric engine 50 and the passenger compartment 80 require cooling. The ambient air/carrier fluid radiator 41 is used to remove the excess of heat. Thus, all components of the thermal management system 10 can be operational in this mode, with the exception of the high voltage heater 40.

The heat is removed from the passenger compartment 80 by means of the evaporator 72 as the third shut-off valve S/O VALVE#3 is open. Of course, the passenger compartment 80 cooling can be disabled by closing the expansion valve EXP VALVE of the passenger compartment evaporator 72.

With reference to Figure 9, a sixth operating mode of the thermal management system 10 is again partial cooling. According to this mode, in fact, the energy source 55, the inverter 51 and the electric motor 52 require cooling. On the other hand, the speed reducer 53 and the passenger compartment 80 do not require cooling.

The ambient air/carrier fluid radiator 41 should be used to remove the excess of heat by operating the first control valve 46.

According to this mode, the air conditioning system 60 is not active as the passenger compartment 80 does not require air conditioning (both heating and cooling).

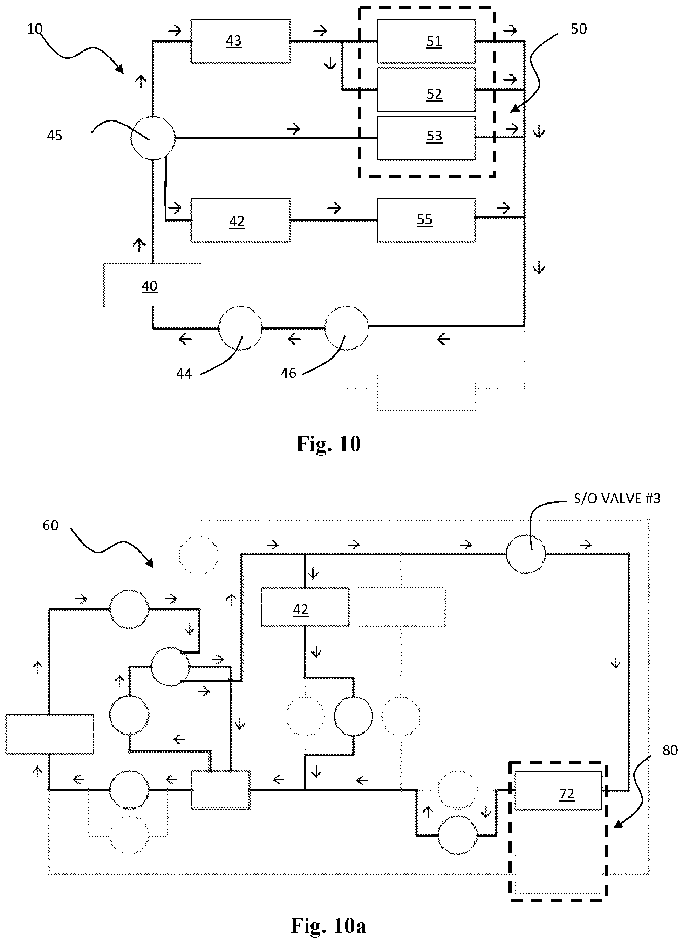

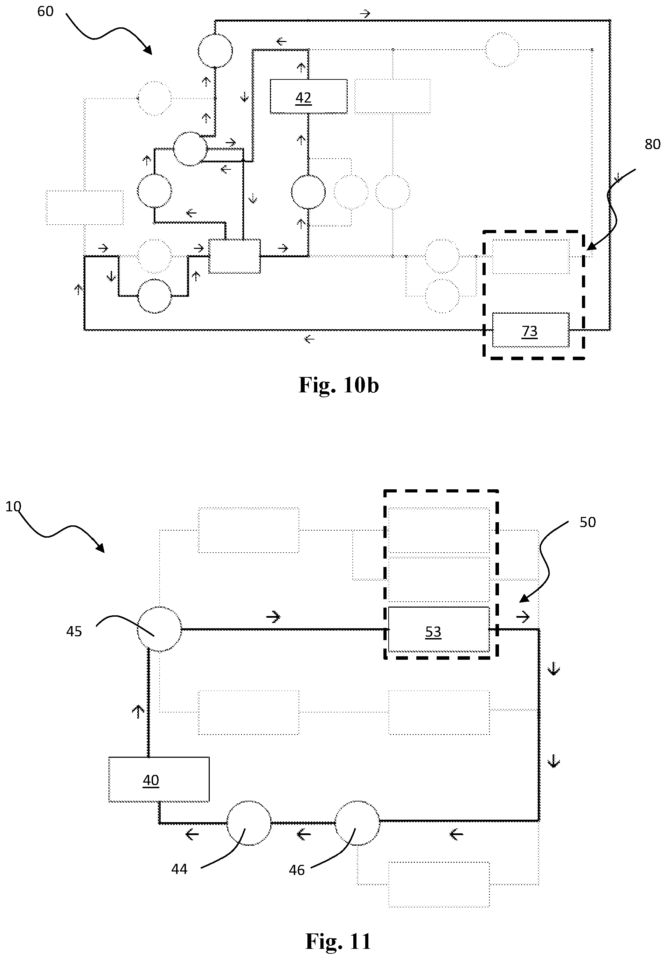

With reference to figures 10, 10a, 10b, a seventh operating mode of the thermal management system 10 is that of total heating, i.e., heating of all the components of the electric powertrain 50, the energy source 55, as well as the passenger compartment 80 of the electric vehicle.

In particular, when the external ambient temperature is suitable for the operation of the conditioning system 60 according to the heat pump mode, the energy source 55 is heated by enabling this mode on the conditioning system 60, i.e., allowing the transfer of heat from the external ambient to the energy source 55 via the first heat exchanger 42. The high voltage heater 40 is turned on. In the thermal management system 10, therefore, all the components are operational except for the ambient air/carrier fluid radiator 41.

With reference to Figure 10a, in the heat pump mode, the air conditioning system can also heat the passenger compartment 80 of the vehicle, by opening the third shut-off valve S/O VALVE#3 and using the evaporator 72 of the passenger compartment 80. This option is suitable because the air conditioning system 60 in the heat pump mode supplies thermal energy with a coefficient of performance (COP) greater than 1.

Since the air conditioning system 60 in the heat pump mode does not operate below certain temperatures (usually, for ambient temperatures below -10° ), when the outdoor ambient temperature is below -10°C it is necessary to activate the heater voltage 40 of the thermal management system 10 to heat the energy source 55.

The first heat exchanger 42 is used to transfer thermal energy to the passenger compartment 80 of the vehicle through the passenger compartment condenser 73 (Figure 10b).

With reference to Figure 11, an eighth operating mode of the thermal management system 10 is a partial heating, in this case the heating of only the speed reducer 53.

According to this mode, it is sufficient that only the high voltage heater 40 is switched on and therefore there is no interaction with the conditioning system 60. In the thermal management system 10, therefore, the pump element 44, the first control valve 46, the second control valve 45 and the high voltage heater 40 are operative.

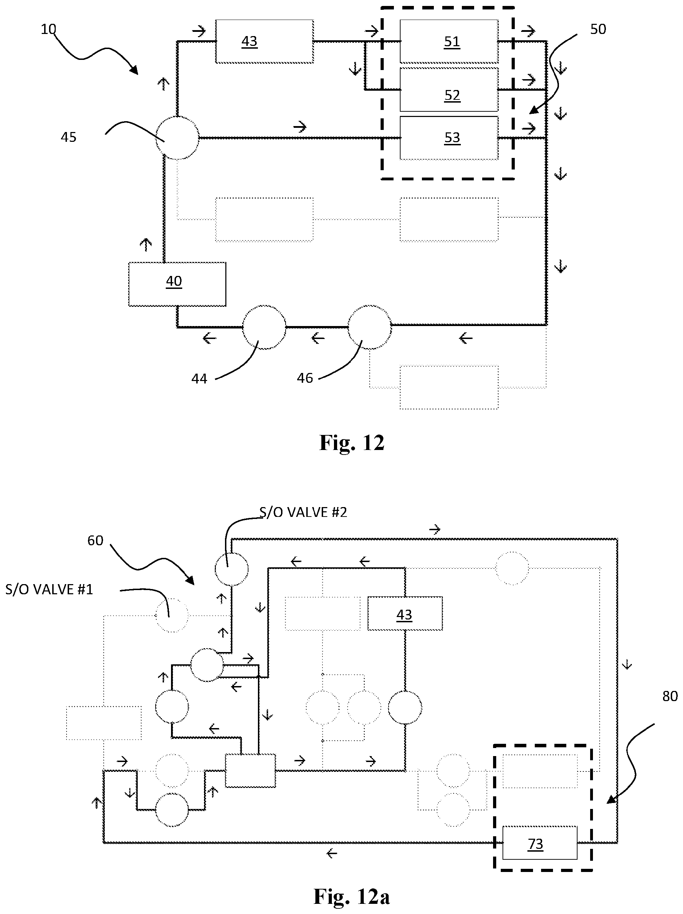

With reference to figures 12 and 12a, a ninth operating mode, particularly advantageous according to the purposes of the present invention, is the so-called hybrid one. According to this mode, the inverter 51 and the electric motor 52 require cooling. On the contrary, the speed reducer 53 and the passenger compartment 80 of the vehicle require heating. The second heat exchanger 43 is used for cooling the inverter 51 and the electric motor 52. The high-voltage heater 40 is on and supplies heat to the speed reducer 53.

The heat, recovered from the second heat exchanger 43 as well as produced by the high voltage heater 40, is used for heating the passenger compartment 80 by means of the condenser 73 as the second shut-off valve S/O VALVE#2 is open. Possibly, the passenger compartment heating 80 could also be assisted by the ambient air condenser 71 by opening the first shut-off valve S/O VALVE#1.

Therefore, all components of the thermal management system 10 are operational in this mode, with the exception of the ambient air/carrier fluid radiator 41 and the first heat exchanger 42. It should be noted that in this operating mode the thermal management system 10 solves the technical problem underlying the present invention, namely that of carrying out simultaneously and independently on the one hand the cooling of the electric motor and the inverter and on the other hand the heating of the speed reducer.

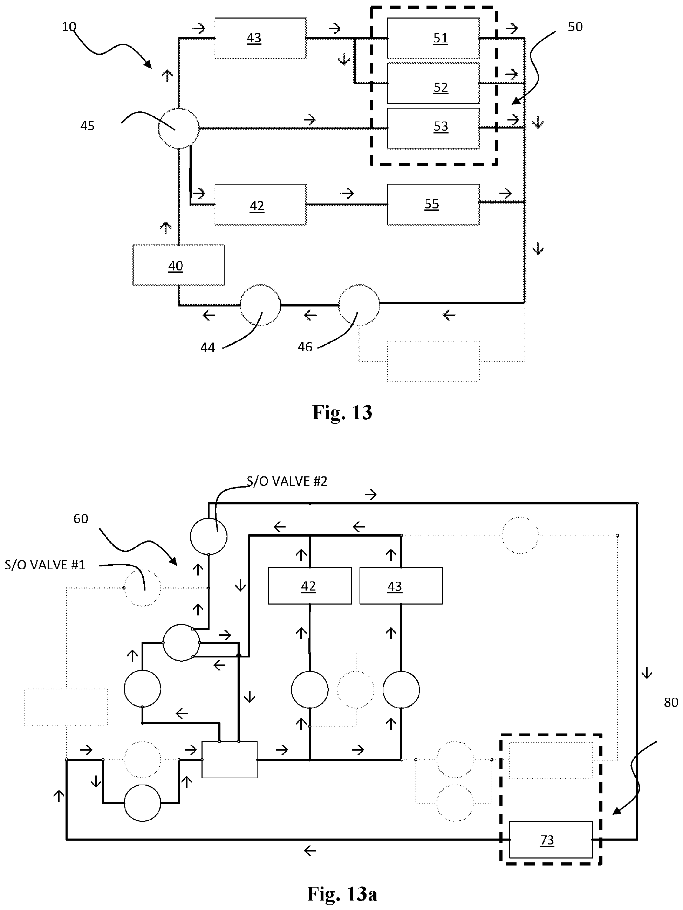

Finally, with reference to Figures 13 and 13a, a tenth operating mode, also this particularly advantageous according to the purposes of the present invention, is still a hybrid mode. According to this mode, the energy source 55, the inverter 51 and the electric motor 52 require cooling. On the contrary, the speed reducer 53 and the passenger compartment 80 of the vehicle require heating. The first heat exchanger 42 is used for cooling the energy source 55 and the second heat exchanger 43 is used for cooling the inverter 51 and the electric motor 52. The high voltage heater 40 is on and supplies heat to the speed reducer 53.

The heat, recovered from the first and second heat exchanger 42, 43 as well as produced by the high voltage heater 40, is used for heating the passenger compartment 80 by means of the condenser 73, the second shut-off valve S/O VALVE#2 being open. Possibly the passenger compartment 80 heating could also be assisted by the ambient air condenser 71 by opening the first shut-off valve S/O VALVE#1.

Therefore, in this mode all the components of the thermal management system 10 are operational, with the exception of the ambient air/carrier fluid radiator 41. It should be noted that also in this operating mode the thermal management system 10 solves the underlying technical problem of the present invention, that is to realize simultaneously and independently on the one hand the cooling of the electric motor, the inverter and the energy source, on the other hand the heating of the speed reducer.

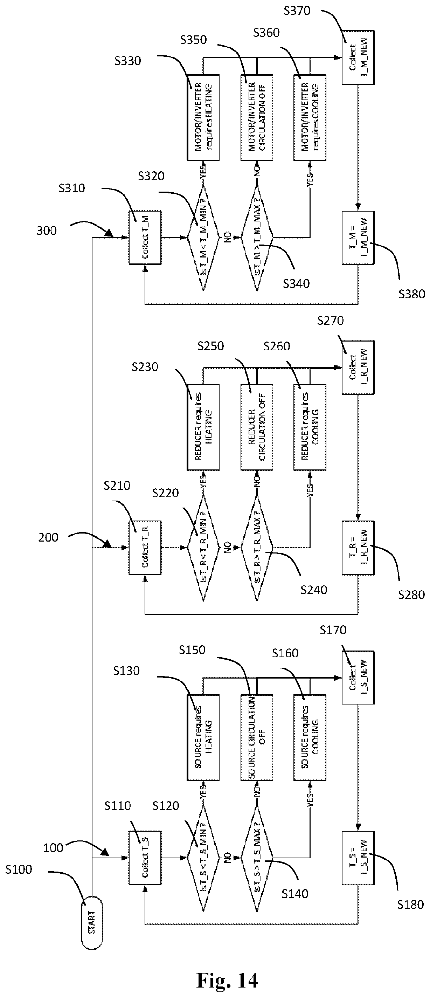

With reference to Figure 14, the method of operating the thermal management system 5 or the thermal management system 10 consists in independently controlling and managing the operating temperature of the electric motor/inverter, speed reducer and energy source. The separate management is highlighted by the presence of three independent branches 100, 200, 300 which respectively manage the temperature T_S of the energy source 55, the temperature T_R of the speed reducer 53 and the temperature T_M of the electric motor 51 and the inverter 52. The temperature control of the respective components is obtained by activating the heating or cooling of the components themselves (independently of one another) according to an appropriate operating mode of the thermal management system 5, 10.

Once the procedure has been activated S100, following the first branch 100, the method acquires S110 the temperature T_S of the energy source 55. If the temperature T_S is lower than a predetermined minimum threshold T_S_MIN (S120), then the method activates S130 the heating of the energy source 55 and proceeds with reading S170 the next temperature value. Otherwise, if the temperature T_S is included in the interval between the minimum threshold T_S_MIN and a predetermined maximum threshold T_S_MAX (S140), then the method decides that the energy source 55 needs neither heating nor cooling and proceeds with reading S170 the next temperature value. Otherwise, the method activates S160 cooling of the energy source 55 and proceeds with reading S170 the next temperature value. Finally, the method equals S180 the next temperature value to the current temperature value T_S and iterates the described logic process.

In parallel, following the second branch 200, the method acquires S210 the temperature T_R of the speed reducer 53. If the temperature T_R is lower than a predetermined minimum threshold T_R_MIN (S220), then the method activates S230 the heating of the speed reducer 53 and proceeds with reading S270 the next temperature value. Otherwise, if the temperature T_R is included in the interval between the minimum threshold T_R_MIN and a predetermined maximum threshold T_R_MAX (S240), then the method decides that the speed reducer 53 needs neither heating nor cooling and proceeds with reading S270 the next temperature value. Otherwise, the method activates S260 the cooling of the speed reducer 53 and proceeds with the reading S270 the next temperature value. Finally, the method equals S280 the next temperature value to the current temperature value T_R and continues with a new iteration.

Finally, always in parallel, following the third branch 300, the method acquires S310 the temperature T_M of the electric motor 51 and the inverter 52. If the temperature T_M is lower than a predetermined minimum threshold T_M_MIN (S320), then the method activates S330 the heating of the electric motor 51 and the inverter 52 and proceeds with reading S370 the next temperature value. Otherwise, if the temperature T_M is included in the interval between the minimum threshold T_M_MIN and a predetermined maximum threshold T_M_MAX (S340), then the method decides that the electric motor 51 and the inverter 52 need neither heating nor cooling and proceeds with the reading S370 of the next temperature value. Otherwise, the method activates S360 the cooling of the electric motor 51 and the inverter 52 and proceeds with reading S370 the next temperature value. Finally, the method equals S380 the next temperature value to the current temperature value T_M and continues with a new iteration.

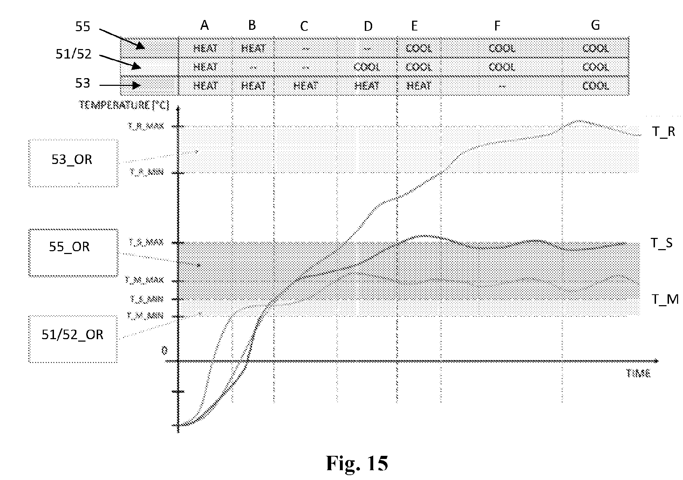

A particular application of the procedure just described is illustrated in figure 15. This is a typical work cycle in the automotive sector, that is cold start. Figure 15 shows the temperature trends as a function of time during this work cycle:
- temperature T_R of the speed reducer 53,
- temperature T_S of the energy source 55,
- temperature T_M of the electric motor/inverter 51, 52,
and the ranges within which the temperatures of each component can vary, between a minimum threshold and a maximum threshold. In detail:
- range 53_OR between T_R_MIN and T_R_MAX, referred to the temperature of the speed reducer 53,
- range 55_OR between T_S_MIN and T_S_MAX, referred to the temperature of the energy source 55,
- range 51 / 52_OR between T_M_MIN and T_M_MAX, referred to the temperature of the electric motor/inverter 51, 52.

As can be seen, the operating temperature range of the speed reducer is higher than that of the other components.

To bring and then maintain the temperatures within the corresponding operating ranges, the general procedure in Figure 14 will apply to each component, based on the current temperature, a heating, a cooling or nothing. The simultaneous and independent combination of these actions constitutes an operating mode of those described above.

Considering, for example, the thermal management system 10, the cold start cycle will be managed as follows:
- starting from a low temperature, for example below 0°C, in a first time interval A all components must be heated. The method will adopt the seventh operating mode of the thermal management system 10, namely that of total heating,
- when the temperature of the electric motor and inverter reaches the minimum temperature threshold T_M_MIN, these components will no longer need heating. Then, in the second time interval B, the speed reducer 53 and the energy source 55 will be heated. The method will adopt the second operating mode of the thermal management system 10, i.e., a partial heating mode,
- once the temperature T_S of the energy source 55 has also exceeded the respective minimum threshold T_S_MIN, in a third time interval C only the gearbox 53 will have to be heated. The method will adopt the eighth operating mode of the thermal management system 10, once more a partial heating mode,
- when the temperature of the electric motor and the inverter reaches the maximum temperature threshold T_M_MAX, these components will need to be cooled. Then, in the fourth time interval D the inverter 51 and the electric motor 52 will be cooled and only the speed reducer 53 will be heated. The method will adopt the ninth operating mode of the thermal management system 10, so-called hybrid mode,
- once the temperature T_S of the energy source 55 has also reached the respective maximum threshold T_S_MAX, in a fifth time interval E, all the components must be cooled with the exception of the speed reducer 53 only, which must continue to be heated. The method will adopt the tenth operating mode of the thermal management system 10, again a so-called hybrid mode,
- once the temperature T_R of the speed reducer 53 has also exceeded the respective minimum threshold T_R_MIN, this component will no longer need to be heated. Then, in a sixth time interval F the remaining components will have to be cooled and the method will adopt the third operating mode of the thermal management system 10, i.e., a partial cooling mode,
- finally, once the temperature T_R of the speed reducer 53 has also reached the respective maximum threshold T_R_MAX, it will be necessary to provide for the cooling of this component as well. Therefore, in a seventh time interval F all the components involved will have to be cooled and the method will adopt the fifth operating mode of the thermal management system 10, namely that of total cooling.

Cold start management is just one example of the possible applications of the thermal management method of the electric powertrain. All other possible operating cycles of the powertrain will be managed with similar, albeit different, sequences of the thermal management system 5, 10.

As is evident from the description of the system and its operating modes, by means of the present invention it is possible to carry out an optimized thermal management of the electric powertrain, as well as (if the thermal management system, according to the invention, interacts with the air conditioning system of the vehicle) the entire electric vehicle. In particular, the performance of the electric powertrain is optimized in terms of efficiency, duration and effectiveness of heating.

In addition to the form of the invention as described above, it must be understood that there are numerous other variants. It must also be understood that these forms of embodiment are merely illustrative and do not limit either the scope of the invention, its applications or its possible configurations. On the contrary, although the above description allows the skilled person to implement the present invention at least according to one exemplary form of embodiment thereof, it should be understood that many variations of the described components are possible, without thereby departing from the scope of the invention as defined in the appended claims.

## Claims

1. Thermal management system (5, 10) for an electric powertrain (50) of an electric-powered vehicle, wherein the electric powertrain (50) comprises an inverter (51), an electric motor (52), a speed reducer (53) and the electric-powered vehicle comprises a power source (55), the thermal management system (5, 10) comprising:
- a single circuit (20) traversed by a single carrier fluid,
- at least one heat exchanger (41, 42, 43) for the heat exchange of the carrier fluid with another working fluid or with the air of the external environment,
- a high voltage heater (40),
- at least a pump element (44) for the circulation of the carrier fluid,
- at least two control valves (45, 46, 47, 48)
wherein the carrier fluid is configured to reach, by means of a plurality of thermally independent branches (21, 22, 23, 24), the inverter (51), the electric motor (52), the speed reducer (53) of the electric powertrain (50) and the power source (55) so as to simultaneously carry out shared thermal exchanges with each component of the electric powertrain (50) and with the power source (55),
**characterized in that** the thermal management system (5, 10) is configured for
- heating the speed reducer (53) by means of the high voltage heater (40) and cooling the inverter (51) and the electric motor (52) through a second heat exchanger (43) in one operating mode, and
- cooling the power source (55) through a first heat exchanger (42) and cooling the inverter (51) and the electric motor (52) through the second heat exchanger (43) in another operating mode.

2. Thermal management system (5) according to claim 1, wherein the first (43) and the second heat exchanger (42) are ambient air/ carrier fluid radiators.

3. Thermal management system (10) according to claim 1, wherein a first and a second heat exchanger (42, 43) belong both to the thermal management system (10) of the electric powertrain (50) and to a conditioning system (60) of the electric-powered vehicle while a third heat exchanger is an ambient air/ carrier fluid radiator (41).

4. Thermal management system (10) according to claim 3 configured according to an operating mode in which
- only the power source (55) is heated by means of the first heat exchanger (42) and/or the high voltage heater (40), or
- the power source (55) and the speed reducer (53) of the electric powertrain (50) are heated by means of the first heat exchanger (42) and/or the high voltage heater (40), or
- only the speed reducer (53) of the electric engine (50) is heated by means of the high voltage heater (40).

5. Thermal management system (10) according to claim 3, configured according to an operating mode in which the power source (55) and the speed reducer (53) of the electric powertrain (50) are heated by means of the first heat exchanger (42) and/or the high voltage heater (40), and the inverter (51) and the electric motor (52) are heated via the second heat exchanger (43).

6. Thermal management system (10) according to claim 3, configured according to an operating mode in which the energy source (55) is cooled by means of the first heat exchanger (42), and
- the inverter (51) and the electric motor (52) are cooled through the second heat exchanger (43), or
- the inverter (51) and the electric motor (52) are cooled through the second heat exchanger (43), while the speed reducer (53) is cooled by the ambient air/ carrier fluid radiator (41).

7. Thermal management system (10) according to claim 3, configured according to an operating mode in which the speed reducer (53) is heated by means of the high voltage heater (40), and
- the inverter (51) and the electric motor (52) are cooled through the second heat exchanger (43), or
- the power source (55) is cooled through the first heat exchanger (42) and the inverter (51) and the electric motor (52) are cooled through the second heat exchanger (43).

8. Method of operating a thermal management system (5, 10) for an electric powertrain (50) of an electric-powered vehicle, the thermal management system (5, 10) being defined according to any of the preceding claims,
the method including the independent and iterative controls of the temperature (T_M) of the inverter (51)/electric motor (52), the temperature (T_R) of the speed reducer (53) and the temperature (T_S) of the source of energy (55), in which each of said temperatures (T_M, T_R, T_S) is controlled:
- activating the heating of at least one of the aforementioned components (51/52, 53, 55) according to at least one operating mode of the thermal management system (5, 10) when the corresponding temperature (T_M, T_R, T_S) is lower than a predetermined minimum temperature threshold (T_M_MIN, T_R_MIN, T_S_MIN), or
- activating the cooling of at least one of the aforementioned components according to at least one operating mode of the thermal management system (5, 10) when the corresponding temperature (T_M, T_R, T_S) is higher than a predetermined maximum temperature threshold (T_M_MAX, T_R_MAX, T_S_MAX).

9. Method according to claim 8, wherein, when the electric powertrain (50) is subjected to a cold start, the time sequence of the operating modes of the thermal management system (5, 10) implemented for the activation of the heating and/or the cooling of said components (51/52, 53, 55) provides:
- an operating mode for heating all components,
- at least one operating mode of partial heating of the components,
- at least one hybrid operating mode, i.e., heating some components and cooling other components,
- an operating mode of partial cooling of the components,
- an operating mode for cooling all components.

## Patentansprüche

1. Wärmemanagementsystem (5, 10) für einen elektrischen Antriebsstrang (50) eines Elektrofahrzeugs, wobei der elektrische Antriebsstrang (50) einen Wechselrichter (51), einen Elektromotor (52) und ein Untersetzungsgetriebe (53) umfasst und das Elektrofahrzeug eine Energiequelle (55) aufweist. Das Wärmemanagementsystem (5, 10) umfasst:
- einen einzigen Kreislauf (20), durch den ein Trägerfluid fließt,
- mindestens einen Wärmetauscher (41, 42, 43) zum Wärmeaustausch des Trägerfluids mit einem anderen Arbeitsfluid oder mit der Umgebungsluft,
- eine Hochspannungsheizung (40),
- mindestens ein Pumpenelement (44) zur Zirkulation des Trägerfluids,
- mindestens zwei Steuerventile (45, 46, 47, 48),
wobei das Trägerfluid über mehrere thermisch unabhängigen Zweige (21, 22, 23, 24) den Wechselrichter (51), den Elektromotor (52), das Untersetzungsgetriebe (53) des elektrischen Antriebsstrangs (50) und die Energiequelle (55) erreicht, so dass gleichzeitig ein gemeinsamer Wärmeaustausch mit jeder Komponente des elektrischen Antriebsstrangs (50) und mit der Energiequelle (55) stattfindet,
**dadurch gekennzeichnet, dass** das Wärmemanagementsystem (5, 10) so konfiguriert ist, dass es
- in einem Betriebsmodus das Untersetzungsgetriebe (53) mittels der Hochspannungsheizung (40) erwärmt und den Wechselrichter (51) und den Elektromotor (52) über einen zweiten Wärmetauscher (43) kühlt, und
- in einem anderen Betriebsmodus die Energiequelle (55) über einen ersten Wärmetauscher (42) und den Wechselrichter (51) und den Elektromotor (52) über den zweiten Wärmetauscher (43) kühlt.

2. Wärmemanagementsystem (5) nach Anspruch 1, wobei der erste (43) und der zweite Wärmetauscher (42) Umgebungsluft-/Trägerflüssigkeitskühler sind.

3. Wärmemanagementsystem (10) nach Anspruch 1, wobei ein erster und ein zweiter Wärmetauscher (42, 43) sowohl zum Wärmemanagementsystem (10) des elektrischen Antriebsstrangs (50) als auch zum Klimaanlagensystem (60) des Elektrofahrzeugs gehören, während ein dritter Wärmetauscher ein Umgebungsluft-/Trägerflüssigkeitskühler (41) ist.

4. Wärmemanagementsystem (10) nach Anspruch 3, konfiguriert gemäß einem Betriebsmodus, in dem
- nur die Energiequelle (55) mittels des ersten Wärmetauschers (42) und/oder der Hochspannungsheizung (40) erwärmt wird, oder
- die Energiequelle (55) und das Untersetzungsgetriebe (53) des elektrischen Antriebsstrangs (50) mittels des ersten Wärmetauschers (42) und/oder der Hochspannungsheizung (40) erwärmt werden, oder
- nur das Untersetzungsgetriebe (53) des Elektromotors (50) mittels der Hochspannungsheizung (40) erwärmt wird.

5. Wärmemanagementsystem (10) nach Anspruch 3, konfiguriert nach einem Betriebsmodus, in dem die Energiequelle (55) und das Untersetzungsgetriebe (53) des elektrischen Antriebsstrangs (50) mittels des ersten Wärmetauschers (42) und/oder der Hochspannungsheizung (40) beheizt werden und der Wechselrichter (51) und der Elektromotor (52) über den zweiten Wärmetauscher (43) beheizt werden.

6. Wärmemanagementsystem (10) nach Anspruch 3, konfiguriert gemäß einem Betriebsmodus, in dem die Energiequelle (55) mittels des ersten Wärmetauschers (42) gekühlt wird und
- der Wechselrichter (51) und der Elektromotor (52) durch den zweiten Wärmetauscher (43) gekühlt werden, oder
- der Wechselrichter (51) und der Elektromotor (52) durch den zweiten Wärmetauscher (43) gekühlt werden, während das Untersetzungsgetriebe (53) durch den Umgebungsluft-/Trägerflüssigkeitskühler (41) gekühlt wird.

7. Wärmemanagementsystem (10) nach Anspruch 3, konfiguriert gemäß einem Betriebsmodus, in dem das Untersetzungsgetriebe (53) mittels der Hochspannungsheizung (40) beheizt wird und
- der Wechselrichter (51) und der Elektromotor (52) über den zweiten Wärmetauscher (43) gekühlt werden, oder
- die Energiequelle (55) über den ersten Wärmetauscher (42) gekühlt wird und der Wechselrichter (51) und der Elektromotor (52) über den zweiten Wärmetauscher (43) gekühlt werden.

8. Verfahren zum Betrieb eines Wärmemanagementsystems (5, 10) für einen elektrischen Antriebsstrang (50) eines Elektrofahrzeugs, wobei das Wärmemanagementsystem (5, 10) gemäß einem der vorhergehenden Ansprüche definiert ist,
das Verfahren umfasst die unabhängige und iterative Regelung der Temperatur (T_M) des Wechselrichters (51)/Elektromotors (52), der Temperatur (T_R) des Untersetzungsgetriebes (53) und der Temperatur (T_S) der Energiequelle (55), wobei jede der genannten Temperaturen (T_M, T_R, T_S) wie folgt geregelt wird:
- Aktivierung der Heizung mindestens einer der vorgenannten Komponenten (51/52, 53, 55) gemäß mindestens einem Betriebsmodus des Wärmemanagementsystems (5, 10), wenn die entsprechende Temperatur (T_M, T_R, T_S) unter einen vorgegebenen Mindesttemperaturschwellenwert (T_M_MIN, T_R_MIN, T_S_MIN) fällt, oder
- Aktivierung der Kühlung von mindestens eine der oben genannten Komponenten gemäß mindestens einem Betriebsmodus des Wärmemanagementsystems (5, 10), wenn die entsprechende Temperatur (T_M, T_R, T_S) einen vorbestimmten maximalen Temperaturschwellenwert (T_M_MAX, T_R_MAX, T_S_MAX) überschreitet.

9. Verfahren nach Anspruch 8, wobei beim Kaltstart des elektrischen Antriebsstrangs (50) die zeitliche Abfolge der Betriebsmodi des zur Aktivierung der Heizung und/oder Kühlung der Komponenten (51/52, 53, 55) implementierten Wärmemanagementsystems (5, 10) Folgendes vorsieht:
- einen Betriebsmodus zum Beheizen aller Komponenten,
- mindestens einen Betriebsmodus zum teilweisen Beheizen der Komponenten,
- mindestens einen Hybridbetriebsmodus, d. h. zum Beheizen einiger und Kühlen anderer Komponenten,
- einen Betriebsmodus zum teilweisen Kühlen der Komponenten,
- einen Betriebsmodus zum Kühlen aller Komponenten.

## Revendications

1. Système de gestion thermique (5, 10) pour un groupe motopropulseur électrique (50) d'un véhicule électrique, ladite groupe motopropulseur électrique (50) comprenant un onduleur (51), un moteur électrique (52) et un réducteur de vitesse (53), et le véhicule électrique comprenant une source d'énergie (55), le système de gestion thermique (5, 10) comprend :
- un circuit unique (20) parcouru par un fluide porteur unique,
- au moins un échangeur de chaleur (41, 42, 43) pour l'échange thermique du fluide porteur avec un autre fluide de travail ou avec l'air ambiant,
- un élément chauffant haute tension (40),
- au moins un élément de pompe (44) pour la circulation du fluide porteur,
- au moins deux vannes de régulation (45, 46, 47, 48)
dans lesquelles le fluide porteur est configuré pour atteindre, par l'intermédiaire de plusieurs branches thermiquement indépendantes (21, 22, 23, 24), l'onduleur (51), le moteur électrique (52), réducteur de vitesse (53) du groupe motopropulseur électrique (50) et source d'énergie (55) afin de réaliser simultanément des échanges thermiques partagés avec chaque composant du groupe motopropulseur électrique (50) et avec la source d'alimentation (55),
**caractérisé en ce que** le système de gestion thermique (5, 10) est configuré pour
- chauffer le réducteur de vitesse (53) au moyen du réchauffeur haute tension (40) et refroidir l'onduleur (51) et le moteur électrique (52) à travers un deuxième échangeur de chaleur (43) dans un mode de fonctionnement, et
- refroidir la source d'énergie (55) à travers un premier échangeur de chaleur (42) et refroidir l'onduleur (51) et le moteur électrique (52) à travers le deuxième échangeur de chaleur (43) dans un autre mode de fonctionnement.

2. Système de gestion thermique (5) selon la revendication 1, dans lequel le premier (43) et le deuxième échangeur de chaleur (42) sont des radiateurs à air ambiant/fluide porteur.

3. Système de gestion thermique (10) selon la revendication 1, dans lequel un premier et un deuxième échangeur de chaleur (42, 43) appartiennent à la fois au système de gestion thermique (10) du groupe motopropulseur électrique (50) et à un système de climatisation (60) du véhicule électrique, tandis qu'un troisième échangeur de chaleur est un radiateur à air ambiant/fluide porteur (41).

4. Système de gestion thermique (10) selon la revendication 3, configuré selon un mode de fonctionnement dans lequel :
- seule la source d'énergie (55) est chauffée au moyen du premier échangeur de chaleur (42) et/ou du réchauffeur haute tension (40) ; ou
- la source d'énergie (55) et le réducteur de vitesse (53) du groupe motopropulseur électrique (50) sont chauffés au moyen du premier échangeur de chaleur (42) et/ou du réchauffeur haute tension (40) ; ou
- seul le réducteur de vitesse (53) du moteur électrique (50) est chauffé au moyen du réchauffeur haute tension (40).

5. Système de gestion thermique (10) selon la revendication 3, configuré selon un mode de fonctionnement dans lequel la source d'énergie (55) et le réducteur de vitesse (53) du groupe motopropulseur électrique (50) sont chauffés au moyen du premier échangeur de chaleur (42) et/ou du réchauffeur haute tension (40), et l'onduleur (51) et le moteur électrique (52) sont chauffés par l'intermédiaire du second échangeur de chaleur (43).

6. Système de gestion thermique (10) selon la revendication 3, configuré selon un mode de fonctionnement dans lequel la source d'énergie (55) est refroidie au moyen du premier échangeur de chaleur (42), et
- l'onduleur (51) et le moteur électrique (52) sont refroidis par l'intermédiaire du second échangeur de chaleur (43), ou
- l'onduleur (51) et le moteur électrique (52) sont refroidis par l'intermédiaire du second échangeur de chaleur (43), tandis que le réducteur de vitesse (53) est refroidi par le radiateur à air ambiant/fluide porteur (41).

7. Système de gestion thermique (10) selon la revendication 3, configuré selon un mode de fonctionnement dans lequel le réducteur de vitesse (53) est chauffé au moyen du réchauffeur haute tension (40), et
- l'onduleur (51) et le moteur électrique (52) sont refroidis par le deuxième échangeur de chaleur (43), ou
- la source d'énergie (55) est refroidie par le premier échangeur de chaleur (42) et l'onduleur (51) et le moteur électrique (52) sont refroidis par le deuxième échangeur de chaleur (43).

8. Procédé de fonctionnement d'un système de gestion thermique (5, 10) pour un groupe motopropulseur électrique (50) d'un véhicule électrique, ledit système de gestion thermique (5, 10) étant défini selon l'une quelconque des revendications précédentes,
le procédé comprenant la régulation indépendante et itérative de la température (T_M) de l'onduleur (51)/moteur électrique (52), de la température (T_R) du réducteur de vitesse (53) et de la température (T_S) de la source d'énergie (55), chacune de ces températures (T_M, T_R, T_S) étant régulée :
- en activant le chauffage d'au moins un des composants susmentionnés (51/52, 53, 55) selon au moins un mode de fonctionnement du système de gestion thermique (5, 10) lorsque la température correspondante (T_M, T_R, T_S) est inférieure à un seuil de température minimal prédéterminé (T_M_MIN, T_R_MIN, T_S_MIN), ou
- en activant le refroidissement d'au moins un des composants susmentionnés selon au moins un mode de fonctionnement du système de gestion thermique (5, 10) lorsque la température correspondante (T_M, T_R, T_S) est supérieure à un seuil de température maximal prédéterminé (T_M_MAX, T_R_MAX, T_S_MAX).

9. Procédé selon la revendication 8, dans lequel, lors d'un démarrage à froid du groupe motopropulseur électrique (50), la séquence temporelle des modes de fonctionnement du système de gestion thermique (5, 10) mis en œuvre pour l'activation du chauffage et/ou du refroidissement desdits composants (51/52, 53, 55) comprend :
- un mode de fonctionnement pour le chauffage de tous les composants,
- au moins un mode de fonctionnement pour le chauffage partiel des composants,
- au moins un mode de fonctionnement hybride, c'est-à-dire chauffage de certains composants et refroidissement d'autres,
- un mode de fonctionnement pour le refroidissement partiel des composants,
- un mode de fonctionnement pour le refroidissement de tous les composants.
